# EUROPEAN PATENT APPLICATION

(11) **EP 2 775 510 A2**
(43) Date of publication of application: **10.09.2014**
(21) Application number: 14152517.0
(22) Date of filing: 24.01.2014
(51) Int. Cl.: H01L 21/52

(54) **Adhesive material applicator, method of applying adhesive material, and method of manufacturing solid-state image sensing apparatus**

(30) Priority: 04.03.2013 JP 2013041548
(71) Applicant: Ricoh Company Ltd., Tokyo 143-8555 (JP)
(72) Inventor: Inuma, Takehiro, Tokyo 143-8555 (JP)
(74) Representative: Leeming, John Gerard

(57) **Abstract**

An adhesive material applicator includes an application unit (31) and a supply unit (33). The application unit (31) has an edge-shaped tip to apply an adhesive material (23) to a target. The supply unit (33) supplies the adhesive material (23) to the tip of the application unit (31) by sticking the adhesive material (23) to the tip of the application unit (31), and an amount of the adhesive material (23) is adjustable such that application width of the adhesive material (23) to the target has a specified length. A method of applying an adhesive material (23) includes supplying the adhesive material (23) to an edge-shaped tip of an application unit (31) by sticking the tip to a supply stage, where the amount of the adhesive material (23) is adjustable such that application width of the adhesive material (23) on a target has a specified length, and includes applying the adhesive material (23) supplied to the tip to the target by making the tip touch the target.

## Description

### BACKGROUND

### Technical Field

Example embodiments generally relate to an adhesive material applicator, a method of applying an adhesive material, and a method of manufacturing a solid-state image sensing apparatus.

### Background Art

In recent years, sliming down and downsizing of digital cameras and digital video cameras are developing, and the demand for sliming down and downsizing of solid-state image sensing apparatuses that include CCD (charge coupled device) and CMOS (complementary metal oxide semiconductor), which are used for digital cameras and digital video cameras, is also increasing.

In order to meet this demand, methods of packaging solid-state image sensing elements are shifting from a conventional type where an image sensor chip is hermetically sealed by a package of ceramic or the like to a chip-size package type where further downsizing is possible.

Recently, solid-state image sensing apparatuses are used for wide-ranging products such as mobile phones, mobile information terminals, and vehicle-installed cameras, and the demand for sliming down, downsizing, and enhanced performance is increasing.

A solid-state image sensing apparatus of chip-size package has a structure where a light receiving portion is hermetically sealed by surrounding the circumference of a light receiving portion of an image sensor chip with spacer and by setting a cover glass onto the spacer. Packaging of solid-state image sensing apparatuses as wafers has also been suggested. Moreover, a technique has been suggested in which data other than light quantity is additionally obtained by arranging optical elements such as a polarization filter and a color filter below a cover glass, i.e., on an image sensor side.

In such a solid-state image sensing apparatus, optical elements are also divided into areas that correspond to the pixels of solid-state image sensing elements such that distinct polarization information and color information will enter the pixels of the solid-state image sensing elements. If the gap between the optical elements and the solid-state image sensing elements is large, light disperses due to diffraction, and crosstalk occurs.

In order to deal with this problem, the following technique is already known. That is, spacer is formed on a cover glass by patterning a photosensitive resin whose thickness is equal to or less than 10 µm, and the spacer portion is pressed against an image sensor and thermocompression bonding is performed. Accordingly, the cover glass on which optical elements are arranged is integrated with the solid-state image sensing elements, allowing a gap whose thickness is equal to or less than 10 µm.

In regard to this technique, Japanese Patent Application Publication No. 2012-169528 discloses a method of manufacturing a solid-state image sensing apparatus in which an adhesive layer is formed by dripping an infinitesimal amount of UV (ultraviolet) -curable resin on spacer, which is used for controlling the gap between a cover glass and light receiving elements, and then by curing the UV-curable resin. It is known that a dispenser is conventionally used to supply a UV-curable resin.

Moreover, Japanese Patent No. 4247825 (Japanese Patent Application Publication No. 2005-000776) discloses a method and device for pin-transferring a highly adhesive material aiming at efficiently applying a specified amount of highly-adhesive material, where the method is capable of supplying a resin to the tip of a wedge-shaped sharpened pin and transferring the resin to a target with the smallest application diameter being ϕ0.150 mm.

In solid-state image sensing apparatuses with a narrow gap using a photosensitive organic material, the adhesive strength between an image sensor and a cover glass is weak, and thus the cover glass may be detached from the image sensor due to physical shock or thermal shock. In regard to the structure with an adhesive layer provided to increase the adhesive strength between an image sensor and a cover glass, a method of forming such an adhesive layer has not yet been established. For this reason, a light receiving portion of an image sensor tends to be contaminated due to the spread of an adhesive layer caused by the pressure applied when thermocompression bonding is performed after an adhesive is applied.

In order to deal with this problem, only an infinitesimal amount of adhesive should be applied. However, the amount of application tends to be large if a device such as a dispenser is used, and a light receiving portion of an image sensor is contaminated as a result. Moreover, a device such as a dispenser is prone to changes in viscosity of adhesive, and the condition needs to be periodically changed when an infinitesimal adhesive is to be applied. Further, devices capable of applying an infinitesimal amount of adhesive tend to be expensive, and thus it could be financially difficult to install such expensive devices.

When a dispenser is used to apply an adhesive material, there is a limit to the shape of the tip of a dispenser. Accordingly, it is not easy to achieve a smaller application width.

The present invention has been made in view of such circumstances as described above, aiming to prevent a target from being contaminated due to the way an adhesive material is applied, reduce changes in the amount of application due to changes in viscosity of adhesive, and to achieve low-cost adhesive material application.

### SUMMARY

Advantageously, provided are an adhesive material applicator, a method of applying an adhesive material, and a method of manufacturing a solid-state image sensing apparatus in which an image sensor chip is protected by a cover glass and the image sensor chip and the cover glass have space therebetween. The adhesive material applicator includes an application unit and a supply unit. The application unit has an edge-shaped tip to apply an adhesive material to a target. The supply unit supplies the adhesive material to the tip of the application unit by sticking the adhesive material to the tip of the application unit, and the amount of the adhesive material is adjustable such that application width of the adhesive material to the target has a specified length. The method of applying an adhesive material includes supplying the adhesive material to an edge-shaped tip of an application unit by sticking the tip to a supply stage, where the amount of the adhesive material is adjustable such that application width of the adhesive material on a target has a specified length, and includes applying the adhesive material supplied to the tip to the target by making the tip touch the target. The method of manufacturing a solid-state image sensing apparatus includes depositing or applying a material of an optical element onto the cover glass, patterning the material to form the optical element that has a desired optical property, depositing or applying a material of the spacer onto the cover glass to form a spacer material layer of a desired thickness, patterning the spacer material layer into a desired shape to form the spacer by removing a portion of the spacer material layer, applying an adhesive material to the spacer by making a tip of a spatula touch the spacer such that the adhesive material has a specified application width, where the adhesive material is an infinitesimal UV-curable resin or thermosetting resin, and includes forming an adhesive layer by aligning and pressure-bonding the cover glass with the image sensor chip, and then curing the infinitesimal UV-curable resin or thermosetting resin.

According to one aspect of the present invention, it is possible to prevent a target from being contaminated due to the way an adhesive material is applied, reduce changes in the amount of application due to changes in viscosity of adhesive, and to achieve low-cost adhesive material application.

### BRIEF DESCRIPTION OF THE SEVERAL VIEWS OF THE DRAWINGS

A more complete appreciation of the disclosure and many of the attendant advantages and features thereof can be readily obtained and understood from the following detailed description with reference to the accompanying drawings.
FIG. 1 is a schematic section view of a solid-state image sensing apparatus that is manufactured by using an adhesive material applicator according to an example embodiment of the present invention.
FIGS. 2A to 2G are schematic diagrams illustrating the steps of manufacturing a solid-state image sensing apparatus by using the adhesive material applicator of FIG. 1 according to an example embodiment of the present invention.
FIG. 3 is a schematic diagram illustrating how an adhesive material is applied by the adhesive material applicator of FIG. 1 according to an example embodiment of the present invention.
FIG. 4 is a perspective view illustrating how an adhesive material is applied by the adhesive material applicator of FIG. 1 according to an example embodiment of the present invention.
FIG. 5 is a perspective view illustrating how an adhesive material is supplied to the adhesive material applicator of FIG. 1 according to an example embodiment of the present invention.
FIG. 6 is a schematic diagram illustrating how an adhesive material is applied by the adhesive material applicator of FIG. 1 according to an example embodiment of the present invention.
FIG. 7 is a schematic diagram illustrating a side view of FIG. 6.

The accompanying drawings are intended to depict exemplary embodiments of the present disclosure and should not be interpreted to limit the scope thereof. The accompanying drawings are not to be considered as drawn to scale unless explicitly noted.

### DETAILED DESCRIPTION

The terminology used herein is for the purpose of describing particular embodiments only and is not intended to be limiting of the present invention. As used herein, the singular forms "a", "an" and "the" are intended to include the plural forms as well, unless the context clearly indicates otherwise. It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

In describing example embodiments shown in the drawings, specific terminology is employed for the sake of clarity. However, the present disclosure is not intended to be limited to the specific terminology so selected and it is to be understood that each specific element includes all technical equivalents that operate in a similar manner.

A method of manufacturing a solid-state image sensing apparatus according to an example embodiment of the present invention will be described with reference to the accompanying drawings. In the drawings, like reference signs denote like elements, and overlapping description may be simplified or omitted as appropriate.

An adhesive material applicator according to an example embodiment of the present invention will be described with reference to the drawings. The adhesive material applicator according to the example embodiment is characterized as follows in regard to the bonding between a cover glass and an image sensor provided for, for example, a solid-state image sensing apparatus.

An adhesive material applicator according to the example embodiment includes an application unit having an edge-shaped tip configured to apply an adhesive material to a target, and a supply unit configured to supply the adhesive material to the tip by sticking the adhesive material to the supply unit, where the supply unit controls an amount of application such that application width of the adhesive material on the target has a specified length. The adhesive material refers to an adhesive such as a UV-curable resin and a thermosetting resin. The target refers to an adherend to which, for example, an adhesive is applied.

In the example embodiment, a transfer spatula whose tip is shaped like a long spatula is used as an application unit. The transfer spatula will be described later in detail. Note that as long as the tip is shaped like a long spatula, the application unit is not limited to a transfer spatula. If the application unit whose edge-shaped tip is shaped like a spatula is used, it becomes possible to apply adhesive with an extra-fine line that is, for example, equal to or thinner than 0.1 mm.

It is preferred that the maximum width of a shorter side of the tip of the application unit according to the example embodiment be equal to or less than 0.1 mm. In order to achieve even finer line application, it is desired that the maximum width of the tip side be as thin as possible.

The supply unit is, for example, a supply stage that supplies adhesive to the tip of the transfer spatula. The supply stage will be described later in detail. In order to achieve the application of a line that is equal to or thinner than 0.1 mm as described above, it is preferred that the thickness of a supply layer of adhesive be equal to or less than 0.5 mm on the supply stage. When the thickness of the supply layer is thin, the amount of adhesive supplied to the tip of the transfer spatula becomes small. Accordingly, it becomes possible to perform even finer line application. The edge-shaped tip also contributes to finer line application.

In order to achieve line application of a desired width, a specified adjusting unit may adjust the thickness of the supply layer. For example, such an adjusting unit has a scale for adjustment perpendicular to the supply stage, and an adhesive is injected to the supply stage in accordance with the scale. Alternatively, a unit may regulate the amount of injection of adhesive to achieve a desired thickness.

If the adhesive material applicator according to the example embodiment is used to apply an adhesive by transfer with a transfer spatula, the tip of the transfer spatula is edge-shaped and an adhesive is transferred to a target. Accordingly, infinitesimal line-application is achieved. Moreover, as a transfer method is adopted, line application can be performed without being affected by changes in viscosity of an adhesive material. A well-known driving unit provided with a drive motor or the like may be used to move the transfer spatula to a supply stage or target.

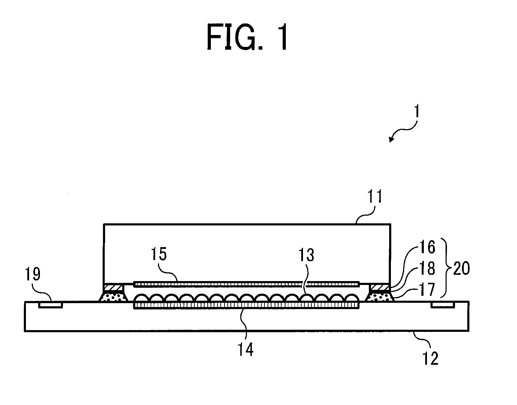

An outline of a solid-state image sensing apparatus 1 that is manufactured by using an adhesive material applicator according to an example embodiment of the present invention will be described with reference to FIG. 1. The solid-state image sensing apparatus 1 includes a cover glass 11, an image sensor chip 12, microlenses 13, a light receiving element 14, an optical element 15, joints 20, and electrodes 19.

The cover glass 11 is provided to protect the light receiving area of the image sensor chip 12 from dust. The image sensor chip 12 is a main substrate, which may be referred to as the core of the solid-state image sensing apparatus 1. The microlenses 13 are formed on the light receiving surface of the light receiving element 14 to concentrate light. The light receiving element 14 is formed on the image sensor chip 12.

The optical element 15 is arranged so as to face the light receiving surface of the light receiving element 14, allowing some space therebetween, and is formed on the surface of the cover glass 11 that faces the light receiving element 14. The joints 20 connect the image sensor chip 12 to the cover glass 11 at points of the outside diameter of the light receiving element 14, i.e., at points of the circumference of the light receiving element 14.

The electrodes 19 are formed on the image sensor chip 12, and transmit the signals output from the light receiving element 14. The output from the light receiving element 14 is retrieved from the electrodes 19.

Each of the joints 20 includes a spacer 16, a protective layer 17, and an adhesive layer 18. The spacer 16 is fixed onto the cover glass 11, and controls the gap between the cover glass 11 and the light receiving element 14. The protective layer 17 is fixed onto a side of the image sensor chip 12 so as to protect the wiring on the image sensor chip 12. The adhesive layer18 connects the spacer 16 to the protective layer 17. The adhesive layer 18 is arranged so as to improve the connection between the cover glass 11 and the image sensor chip 12.

In the solid-state image sensing apparatus 1 configured as above, light passes through the cover glass 11 and the optical element 15, and enters the light receiving element 14. As the light passes through the optical element 15, polarization information or color information can be obtained in addition to the light quantity.

The gap between the cover glass 11 and the image sensor chip 12 is controlled by the spacer 16, such that the space will be equal to or narrower than 10 µm. Accordingly, it becomes possible to prevent the light that has passed through a certain area of the optical element 15 from spreading due to diffraction and entering pixels other than the pixels of the light receiving element 14.

The adhesive layer 18 can be made as thin as 100 nm by being pressurized after dripping an infinitesimal resin. Thus, the adhesive layer 18 does not expand the gap between the cover glass 11 and the image sensor chip 12. Accordingly, noise due to crosstalk decreases in the solid-state image sensing apparatus 1, and information that is more accurate can be obtained.

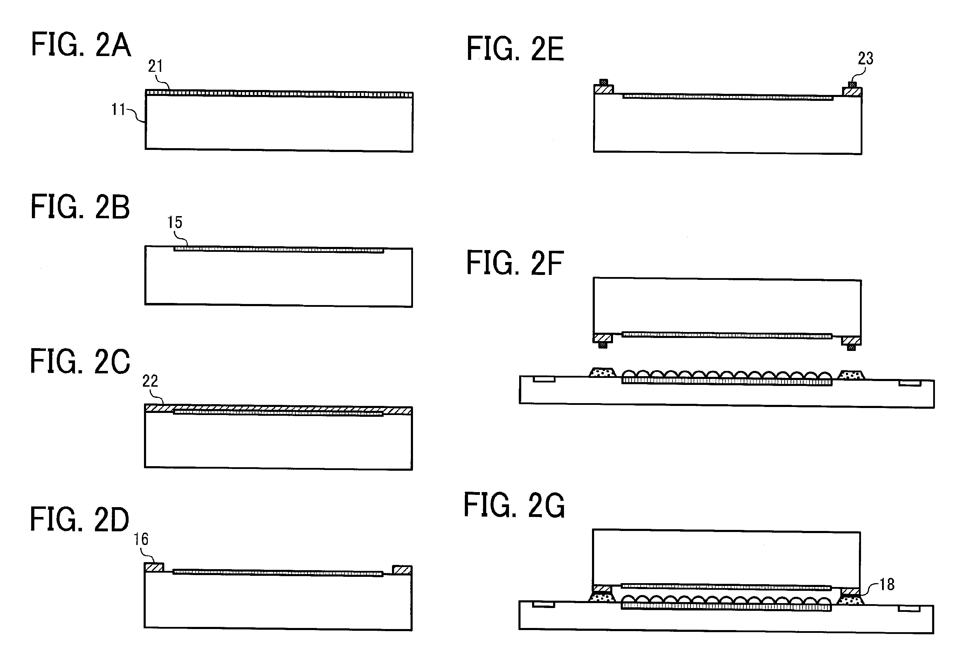

Next, a method of manufacturing the solid-state image sensing apparatus 1 according to an example embodiment of the present invention is described with reference to FIG. 2. Firstly, in the process of FIG. 2A, a material 21 of the optical element 15 is deposited or applied onto the cover glass 11. Various kinds of substance may be used for the material 21 depending on the type of the optical element 15.

Next, in the process of FIG. 2B, the material 21 is patterned so as to form the optical element 15 with a desired optical property. Note that a method of manufacturing the optical element 15 is not limited to the method described with reference to FIGS. 2A and 2B where the material 21 is deposited onto the cover glass 11 and is patterned. For example, some optical functions may be achieved by forming fine patterns on a cover glass or depositing a material on the cover glass like anti-reflection coating.

In the process of FIG. 2C, after the optical element 15 is formed onto the cover glass 11, a material of the spacer 16 is deposited or applied onto the cover glass 11, and a spacer material layer 22 of a desired thickness is formed. After that, in the process of FIG. 2D, the spacer material layer 22 is patterned into a desired shape by performing development, or a removal process such as etching and lift-off. A spacer material may be formed into the spacer 16 of a desired pattern by using a stencil mask or the like.

Next, in the process of FIG. 2E, an adhesive 23 such as an infinitesimal UV-curable resin or thermosetting resin is dripped onto the spacer 16. In this process, the adhesive material applicator according to an example embodiment of the present invention is used. For example, the adhesive 23 is applied onto the spacer 16 as a tip of a long spatula, to which the adhesive 23 is supplied such that the application width of the adhesive 23 will be equal to or narrower than 0.1 mm, touches the spacer 16.

Then, in the process of FIGS. 2F and 2G, the cover glass 11 and the image sensor chip 12 are aligned such that the pixels of the light receiving element 14 will match the corresponding areas of the optical element 15, and are bonded with pressure. After the cover glass 11 and the image sensor chip 12 are bonded with pressure, the adhesive layer 18 is formed by curing the resin. Note that UV-irradiation is used when a UV-curable resin is used, and the resin is heated when a thermosetting resin is used.

According to the processes described above, the distance between the light receiving element 14 and the optical element 15 is controlled to be equal to or shorter than 10µm, and the adhesion between the cover glass 11 and the image sensor chip 12 can be improved.

As described above, the cover glass 11 provided with the optical element 15, the spacer 16 whose thickness is equal to or less than 10 µm formed on the cover glass 11, and the image sensor chip 12 are bonded to each other by using an infinitesimal amount of UV-curable resin or thermosetting resin that is dripped onto the spacer 16.

If the configuration as above is adopted, the spacer material is not limited to a photosensitive resin but may be a thin film made by using sputtering or CVD (chemical-vapor deposition) to deposit a metal material or inorganic material such as Si, SiO₂, and SiN, and the thickness may be precisely determined as thin as submicron to 10µm.

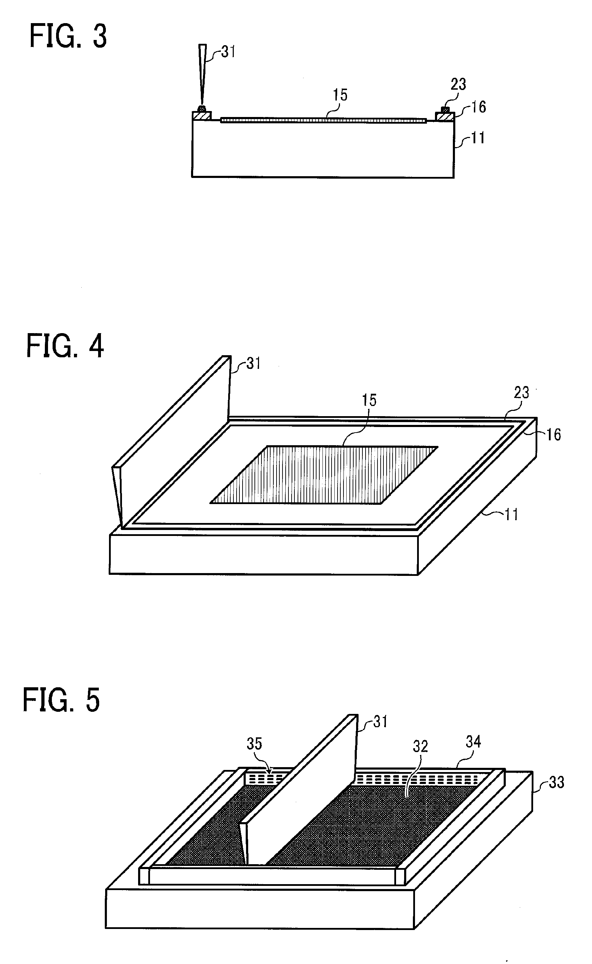

Next, a method of applying an adhesive material by using an adhesive material applicator according to an example embodiment of the present invention is described with reference to FIG. 3. FIG. 3 illustrates the cover glass 11 that is being processed in the process of FIG. 2E. In the example embodiment, a transfer spatula 31 with an edge-shaped tip is used to transfer the adhesive 23 to the spacer 16, which is formed on the cover glass 11. Because the tip of the transfer spatula 31 is edge-shaped, infinitesimal application of the adhesive 23 becomes possible with the width of 0.1mm at the time of transfer.

Note that the transfer spatula 31 with a long tip is used in the example embodiment in order to achieve line-application of an adhesive, but there should be no limitation to line-application and point-application of an adhesive may be achieved. In the example embodiment, the solid-state image sensing apparatus 1 is the target to which an adhesive is to be applied, and line-application is performed to attach the cover glass 11 that protects the image sensor chip 12.

When point-application is to be performed, application means with an edge-shaped tip, for example, a needle, may be used. Point-application is achieved as follows. An adhesive is applied to a tip of the application means such that the amount of adhesive will be just sufficient to achieve a desired width of application, and the tip touches a target.

JP-4247825-B1 (JP-2005-000776-A) discloses a pin transfer method where the tip of a transfer pin is sharpened like a wedge and the point angle is between 52 and 68 degree, for the purpose of efficiently applying a highly-adhesive material of a specified amount. In the pin transfer method disclosed in JP-4247825-B1 (JP-2005-000776-A), the smallest application diameter in the point application process is 0.15 mm.

In contrast, according to an example embodiment of the present invention, it is possible to form the shape of a point-application tip to be infinitesimally thin like a needle, which is unlike the disclosure in JP-4247825-B1 (JP-2005-000776-A). In other words, it is possible to make the smallest application diameter be, at least, equal to or smaller than 0.1 mm, which is far smaller than that of the disclosure in JP-4247825-B1 (JP-2005-000776-A). It is preferred that the point angle of a tip be equal to or smaller than 33 degree in order to achieve a small application diameter.

Note that the shape of an application unit is not limited to the transfer spatula 31 according to the example embodiment or a needle of the above example, but is variable depending on the shape or state of a target to which an adhesive is to be applied, without departing from the scope of the present invention where an edge-shaped tip is involved.

Next, the cover glass 11 that is being processed as illustrated in FIG. 3 is further described with reference to FIG. 4. In the example embodiment, the transfer spatula 31 is used to transfer the adhesive 23 to the spacer 16 that is formed on four sides of the cover glass 11. As described above, an UV-curable resin or thermosetting resin is used as adhesive.

Next, how an adhesive material applicator according to an example embodiment of the present invention is supplied is described with reference to FIG. 5. Firstly, an adhesive is spread thin on a supply stage 33 to form a supply layer 32 of adhesive, and the transfer spatula 31 approaches the supply layer 32. The thickness of the supply layer 32 can be adjusted depending on the amount of adhesive to be transferred, by using a dam 34 and scales 35 drawn on the dam 34. When the application width of adhesive is to be equal to or narrower than 0.1mm, it is desired that the thickness of the supply layer 32 be about 0.5 mm so as to achieve stable line-application to the transfer spatula 31.

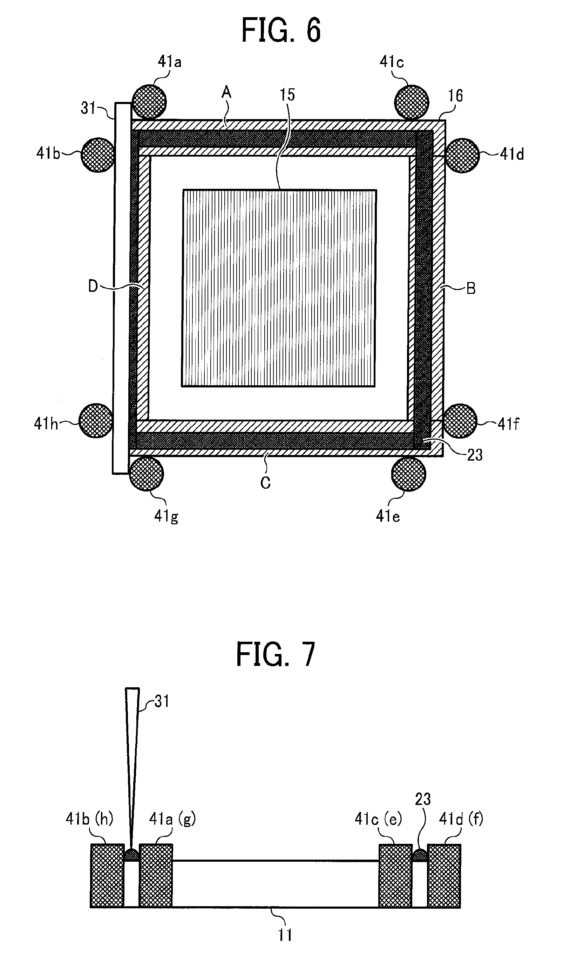

Next, positioning means for positioning the transfer spatula 31 are described with reference to FIGS. 6 and 7. The positioning means are used to prevent the transfer spatula 31 from deviating when the transfer spatula 31 according to an example embodiment of the present invention is used to apply an adhesive is to the targeted spacer 16. For example, positioning pins 41 are used as positioning means of the example embodiment.

The positioning pins 41 are positioned near the corners of the targeted cover glass 11 so as to be horizontally slidable, and are arranged so as to face each other with space equivalent to the width of an edge of the transfer spatula 31. In the example embodiment, two positioning pins 41 are arranged across each one of the four corners of the cover glass 1.

More specifically, positioning pins 41a and 41b are arranged to face each other at the top-left corner of the cover glass 11 of FIG. 6, and positioning pins 41c and 41d are arranged to face each other at the top-right corner of FIG. 6. Moreover, positioning pins 41e and 41f are arranged to face each other at the bottom-right corner of FIG. 6, and positioning pins 4 1 g and 41h are arranged to face each other at the bottom-left corner of FIG. 6. In the following description, the areas formed on the four sides of the cover glass 11 in which the spacer 16 is arranged are referred to as a top-side area A, a right-side area B, a bottom-side area C, and a left-side area D, respectively.

For example, when an adhesive is to be applied to the spacer 16 on the left-side area D in FIG. 6, the transfer spatula 31 is positioned such that the both ends of the transfer spatula 31 are sandwiched by the positioning pins 41a and 41b, which are arranged to face each other at the top-left corner with space equivalent to the width of an edge of the transfer spatula 31, and the positioning pins 41g and 41h, which are arranged to face each other at the bottom-left corner with space equivalent to the width of an edge of the transfer spatula 31.

In other words, line-application of adhesive can precisely be performed by adjusting the transfer spatula 31 to touch the spacer 16 between the positioning pins 41 a and 41 g and the positioning pins 41b and 41h.

A similar operation is performed when an adhesive is to be applied to the spacer 16 on the sides other than the left-side area D. As the positioning pins 41 are arranged so as to be horizontally slidable, the positioning pins 41 can move freely in accordance with the shape of a target. An apparatus uses a well-known image processing unit to recognize the positions of the positioning pins 41, thereby determining positions to which an adhesive is to be applied. Although the section-view of the positioning pins 41 is circular in the example embodiment, the shape of the positioning pins 41 is not limited to a circular shape.

According to the example embodiment, a transfer spatula whose tip is edge-shaped is used to transfer an adhesive to a target. Accordingly, infinitesimal line-application is achieved. Moreover, as a transfer method is employed, line application can be performed without being affected by changes in viscosity of an adhesive material. Further, the adhesive strength between a cover glass and an image sensor provided for a solid-state image sensing apparatus can be improved, and it becomes possible to prevent the light receiving portion of the image sensor from being soiled due to infinitesimal application. Further, it becomes possible to provide a transferring device and method at low cost where the amount of application is not variable depending on the viscosity of adhesive and a specified amount of adhesive can be applied in lines.

Note that the embodiments described above are preferred example embodiments of the present invention, and various applications and modifications may be made without departing from the scope of the invention. In the embodiments described above, an adhesive material applicator and a method of applying an adhesive were exclusively described in regard to the application of an adhesive to a target in the manufacturing process of a solid-state image sensing apparatus. However, such an adhesive material applicator and a method of applying an adhesive may be applied to any potential production in which an infinitesimal adhesive material other than an adhesive is applied.

## Claims

1. An adhesive material applicator comprising:
an application unit (31) having an edge-shaped tip configured to apply an adhesive material (23) to a target; and
a supply unit (33) configured to supply the adhesive material (23) to the tip of the application unit (31) by sticking the adhesive material (23) to the tip of the application unit (31), an amount of the adhesive material (23) being adjustable such that application width of the adhesive material (23) to the target has a specified length.

2. The adhesive material applicator according to claim 1, wherein maximum width of a shorter side of the tip is approximately equal to or less than 0.1 mm.

3. The adhesive material applicator according to claim 1 or 2, wherein the supply unit (33) includes a supply layer (32) of the adhesive material (23) whose thickness is approximately equal to or less than 0.5 mm.

4. The adhesive material applicator according to any one of claims 1 to 3, wherein the supply unit (33) includes an adjusting unit (34, 35) that adjusts thickness of a supply layer (32) of the adhesive material (23).

5. The adhesive material applicator according to any one of claims 1 to 4, wherein the application unit (31) has a tip shaped like a long spatula.

6. The adhesive material applicator according to claim 5, further comprising positioning units (41) arranged near corners of the target, the positioning units (41) being horizontally slidable and facing each other with space equivalent to width of an edge of the application unit (31).

7. A method of applying an adhesive material (23), the method comprising:
supplying the adhesive material (23) to an edge-shaped tip of an application unit (31) by sticking the tip to a supply stage, an amount of the adhesive material (23) being adjustable such that application width of the adhesive material (23) on a target has a specified length; and
applying the adhesive material (23) supplied to the tip to the target by making the tip touch the target.

8. The method according to claim 7, wherein the supplying supplies the adhesive material (23) such that application width of the adhesive material (23) to the target is approximately equal to or less than 0.1 mm.

9. The method according to claim 7 or 8, wherein thickness of the adhesive material (23) on the supply stage is approximately equal to or less than 0.5 mm.

10. A method of manufacturing a solid-state image sensing apparatus (1) in which an image sensor chip (12) is protected by a cover glass (11), the image sensor chip (12) and the cover glass (11) having spacer (16) therebetween, the method comprising:
depositing or applying a material (21) of an optical element (15) onto the cover glass (11);
patterning the material (21) to form the optical element (15) that has a desired optical property;
depositing or applying a material of the spacer (16) onto the cover glass (11) to form a spacer material layer (22) of a desired thickness;
patterning the spacer material layer (22) into a desired shape to form the spacer (16) by removing a portion of the spacer material layer (22);
applying an adhesive material (23) to the spacer (16) by making a tip of a spatula (31) touch the spacer (16) such that the adhesive material (23) has a specified application width, the adhesive material (23) being an infinitesimal UV-curable resin or thermosetting resin; and
forming an adhesive layer (18) by aligning and pressure-bonding the cover glass (11) with the image sensor chip (12), and then curing the infinitesimal UV-curable resin or thermosetting resin.

11. The method according to claim 10, wherein the adhesive material (23) is applied using the adhesive material applying method of claim 7.
